# EUROPEAN PATENT APPLICATION

(11) **EP 1 715 459 A2**
(43) Date of publication of application: **25.10.2006**
(21) Application number: 05109922.4
(22) Date of filing: 24.10.2005
(51) Int. Cl.: G07C 5/08

(54) **Device for the diagnosis of a central unit of an air conditioning system of a vehicle**

(30) Priority: 21.04.2005 IT PR20050020
(71) Applicant: Motorscan S.p.A., 43100 Parma (IT)
(72) Inventor: Valcavi, Lucia, 43100 Parma (IT); Bacchieri, Giuseppe, 43100 Parma (IT); Zuccheri, Giuseppe, 43011 Roncole Verdi di Busseto (IT)
(74) Representative: Gotra, Stefano

(57) **Abstract**

A device (1) for the diagnosis of a central unit of an air conditioning system of a vehicle comprises a microprocessor (6) for processing information, a connector (2) for transmitting information from the central unit to said microprocessor (6) and vice versa, a memory (8) in which is located a resident software which serves as an operating system for the device, interfacing means (2, 3), for transferring input / output information from the device (1) to a user, at least one memory bank (9), of the erasable / rewritable type, in which are located communication protocols, each protocol relating to a type of central unit, and a working software to place the device (1) in communication with a central unit according to a corresponding protocol.

## Description

The present invention relates to a device for the diagnosis of a central unit of an air conditioning system of a vehicle, said device comprising:
- a connector for transmitting information from the central unit to the device and vice versa;
- a microprocessor for processing said information;
- a memory where a resident software, which serves as operating system for the device, is located;
- interfacing means, for transferring input/output information from the device to a user.

The presence of ever more sophisticated air conditioners inside vehicles has entailed the need to provide increasingly complex Electronic Central Units (ECU), to manage the air conditioners. Consequently, with respect to vehicle repair and maintenance, it is essential for all specialised workshops to be able to perform an accurate diagnosis of said Electronic Central Units. Central units that manage air conditioning systems perform numerous functions, enabling the operator who is able to monitor them to fully diagnose the system. In particular, at least the following operations can be performed:
- detecting the presence of failures, verifying their status and causes, as well as the operating conditions in which the anomaly took place;
- deleting the failures stored in the central unit after repairing them, thus extinguishing the indicator light that signalled the malfunction;
- activating relays, motors and actuators;
- displaying parameters and operating states;
- displaying spare part identifier and part number;
- encoding the new central unit if the existing one needs to be replaced;
- resetting the central unit in case of crash or temporary arrest of the system.

Currently, the only diagnostic devices for motor vehicle central units are single-brand instruments provided by the vehicle manufacturers (e.g.: Fiat group testers, Renault testers, etc.). Such instrument, in addition to having the limitation of being able to analyse only central units of a single brand (or even of a determined car model by a determined brand), are not dedicated solely to diagnosing air conditioners, so they are very expensive instruments and they require the user to be particularly accomplished, as well as a long time to access their manifold functions. In addition, it must be considered that, in said devices, performing some functions requires entering particular codes, which are not displayed directly on the device itself, therefore appropriately trained personnel is required to consult the documentation provided by the manufacturer, and then to enter the codes manually.

A further drawback of known diagnostic devices is that said instruments can be purchased only by workshops authorised by the original equipment manufacturer; moreover, they cannot be adapted or modified to enable them to diagnose air conditioners installed on cars of different brands. Therefore, known diagnostic devices are hard to find it, not adaptable to different solutions, and costly.

Another drawback of known diagnostic devices is the considerable bulk of the devices, many of which require special carts for their displacement.

An object of the present invention is to eliminate the aforesaid drawbacks and to make available a device for the diagnosis of a central unit of an air conditioning system of a vehicle, which is able to operate on central units of different brands and is simple and functional for the user.

Said object is fully achieved by the device of the present invention, which is characterised by the content of the claims set out below and in particular in that it comprises at least one memory bank where are located communication protocols, each protocol relating to one type of central unit, and a working software to place the device in communication with a central unit according to a corresponding protocol.

This and other characteristics shall become more readily apparent in the description that follows of a preferred embodiment, illustrated purely by way of non limiting example in the accompanying drawing tables, in which:
- Figure 1 shows a functional diagram of the device of the present invention;
- Figure 2 schematically illustrates the device of Figure 1 and an embodiment variant thereof, connected to a motor car.

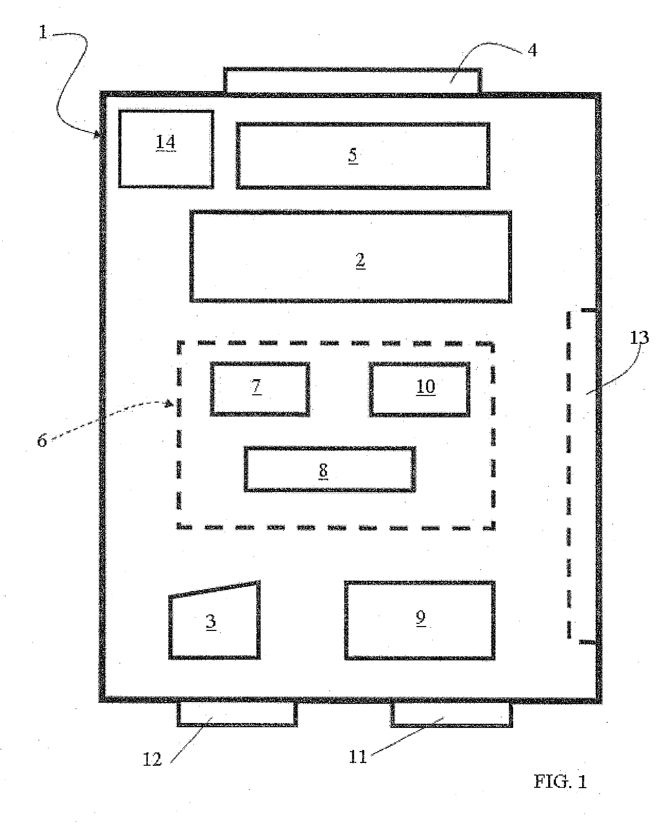

With reference to Figure 1, the number 1 designates the device of the present invention, for the diagnosis of a central unit of an air conditioning system of a vehicle. The device 1 comprises interfacing means, for transferring input/output information from the device 1 to a user. Said means comprise at least one display 2, preferably of the transflective Graphic LCD type, and a keyboard 3, for setting the various functions and commands of the device, for selecting various menus and confirming the measured data, with the possibility of using personalised character types and menus. Using the display, it is possible to have menus for selecting among the various types or brands of vehicles and it is possible to choose the language, the setting of the instrument, and to personalise any printed reports.

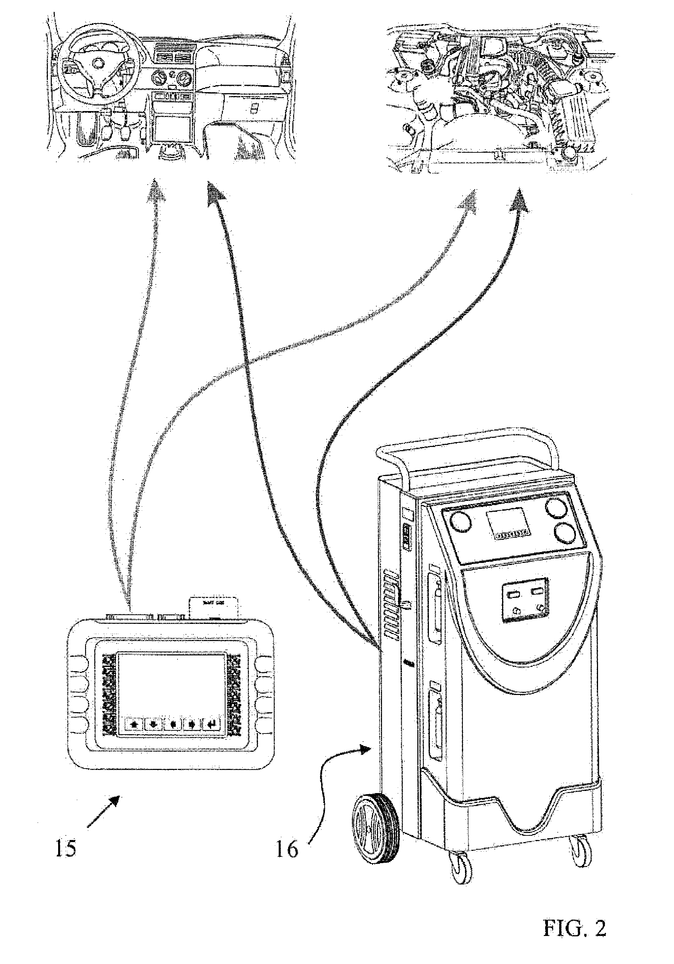

The device 1 comprises a connector 4, whereto is operatively connected a connecting cable between the device 1 and a diagnostic outlet of a vehicle, which can be positioned inside the passenger compartment or in the engine compartment, as schematically shown in Figure 2.

The device 1 further comprises means 5 for driving the input / output signals from the device 1, which operate an automatic selection of the access channel to the central unit. Said driving means 5 interrogate the central unit sending appropriate signals; in response to said signals, the driving means 5 automatically determine the access channel to the central unit (constituted by appropriate pins of the diagnostic outlet of the vehicle); hence, said driving means 5 drive the input / output signals from the device 1 through said channel by means of a router.

Moreover, the device 1 comprises a microprocessor 6, which constitutes the core of the device and comprises a so-called "microchip core" 7, which is the functional part of the device, a memory 8 containing the resident software, or "firmware", which substantially serves as an operating system that oversees the powering and initialisation of the device 1.

The device 1 originally also comprises memory banks 9, preferably of the flash EPROM type, or otherwise of the erasable / rewritable type. On said memory banks 9 is located a plurality of communication protocols, each protocol relating to one type of central unit. On said memory banks 9 is also located a software or work programme, run by the microprocessor 7, to communicate with the various types of central units operating with different communication protocols.

The microprocessor 7 also manages a high speed transmitter 10 for high speed protocol diagnosis (CAN-BUS etc.).

The microprocessor 7 receives commands from the user / operator through the keyboard 3, displays data and results on the display 2 and communicates with the central unit of the vehicle, with no need for the operator to initiate any tuning procedure or to enter particular codes or specifications. This result is obtained, originally, by said driving means 5, in combination with the communication protocols contained in the memory banks 9. The device 1 interrogates the central unit sending appropriate reference signals, then processes these signals thereby directly deriving from the central unit the information required for the diagnosis, said information changing from central unit to central unit.

The device 1 is also provided with a parallel interface 11, preferably of the standard Centronics type, for connection to peripherals, e.g. an 80 column printer to execute and print reports. Moreover, the device 1 comprises a serial interface 12, preferably of the complete RS232 type, e.g. to perform HOST connections or download SW, or to connect a 24 column serial printer or a modem for remote control / remote service. The device 1 further comprises a smart card reader 13, e.g. for the management of protected Smart card, with the possibility of use as prepaid card for updates or as authorisation for remote control to export data to a PC. Therefore, the smart card reader 13 allows remotely to enable / disable means for transferring data from a PC to the device 1 and vice versa. Operatively, to update the device 1, an updating protocol for PC is used, whereby it is possible to provide on a magneto-optical support (CD-ROM) or to download via Internet the update software and to store it in a PC, to then transfer it via serial to the device 1, possibly after authorisation by means of the smart card. In this way, the device 1 originally allows potentially unlimited updating and adaptability to new communication protocols provided by vehicle manufacturers, and to new types of air conditioners to be diagnosed.

The reference number 14 designates a power supply source for the aforementioned electronic parts, with an output voltage of preferably 5 V direct and an input preferably at 12 V, powered by a battery of the vehicle.

The connecting cable between the device 1 and the vehicle can have a branch to the battery or it can be a single cable connected to an outlet of the vehicle; this is the case when the outlet of the vehicle comprises two terminals or pins connected to the battery.

The device of the present invention offers numerous advantages.

In the first place, it is more economical and simpler to be used than known devices, being dedicated exclusively to the diagnosis of central units. The simplicity of use of the device 1 is given originally by the presence of internal memory banks 9 which comprise complete information about a plurality of central units of different types, together with the presence of driving means 5 which guide the user through the diagnosis by means of automatic procedures. Hence, with the device 1 it is not necessary for the user to consult any documentation, because the device 1 itself will guide him/her automatically.

Moreover, the device 1 originally enables to perform updates in real time, thanks to the fact that the information necessary for the diagnosis are contained in a rewritable memory 9 and that the device 1 comprises numerous means for exchanging data / information with the exterior, such as serial interfaces 12 or parallel interfaces 11.

It should be noted that the device 1 not only contains within it all the hardware required to diagnose systems present on vehicles, but it is also compliant with the standards currently being enacted and it is designed in such a way as to be adaptable to the future systems placed on the marked (whereas in the case of known single-brand instruments, which are not designed for a hardware update, it is necessary to change the instrument).

The device 1 may constitute, as schematically illustrated in Figure 2, a rugged and convenient stand-alone portable palmtop device 15, or, according to an embodiment variant, it may be inserted in a machine 16 for recharging air conditioning. In this latter case, the user in fact has a single apparatus available to perform maintenance functions on air conditioners, without any additional bulk with respect to a machine dedicated exclusively to recharging air conditioning.

Moreover, the device 1 is particularly reliable, thanks to the fact that it originally comprises driving means 5 able automatically to perform the routing of the correct pin in a diagnostic outlet of the car to be tested, without forcing the user to connect manually to the pin of the diagnosis outlet, which would entail time wastage and the risk of severely damaging the device because of possible short circuits.

## Claims

1. Device (1) for the diagnosis of a central unit of an air conditioning system of a vehicle, comprising:
- a microprocessor (6) for processing information;
- a connector (2) for transmitting information from the central unit to the microprocessor (6) and vice versa;
- a memory (8) where a resident software, which serves as operating system for the device, is located;
- interfacing means (2, 3), for transferring input/output information from the device (1) to a user;
**characterised in that** it comprises at least one memory bank (9) where are located communication protocols, each protocol relating to one type of central unit, and a working software to place the device (1) in communication with a central unit according to a corresponding protocol.

2. Device as claimed in claim 1, **characterised in that** said at least one memory bank (9) is of the erasable / rewritable type.

3. Device as claimed in claim 2, **characterised in that** it comprises means for modifying / updating the content of said at least one memory bank (9).

4. Device as claimed in claim 3, wherein the means for modifying / updating the content of said at least one memory bank (9) comprise a PC, an updating protocol for said PC and means for transferring data from the PC to the device and vice versa.

5. Device as claimed in claim 4, **characterised in that** it comprises at least one smart card reader (13), to remotely enable said means for transferring data from the PC to the device.

6. Device as claimed in any of the previous claims, wherein said interfacing means comprise a transflective graphic display (2) and a keyboard (3).

7. Device as claimed in any of the previous claims, wherein said interfacing means (2, 3) enable the user to enter / display information through personalised menus and/or character types.

8. Device as claimed in any of the previous claims, comprising means (5) for driving the input / output signals from the device 1, through an automatically selected access channel to the central unit.

9. Device as claimed in any of the previous claims, comprising a high speed transmitter (10), operatively connected to the microprocessor (7) to run high speed communication protocols.

10. Device as claimed in any of the previous claims, comprising at least one parallel interface (11) for connecting the device (1) to external peripherals.

11. Device as claimed in any of the previous claims, comprising at least one serial interface (12) for connecting the device (1) to external peripherals / modems.
